# EUROPEAN PATENT APPLICATION

(11) **EP 4 749 841 A1**
(43) Date of publication of application: **27.05.2026**
(21) Application number: 25744627.8
(22) Date of filing: 22.01.2025
(51) Int. Cl.: H01R 13/648, H05K 1/02

(54) **ELECTRONIC DEVICE**

(30) Priority: 22.01.2024 CN 202410086776
(71) Applicant: Honor Device Co., Ltd., Shenzhen, Guangdong 518040 (CN)
(72) Inventor: WANG, Yu, Shenzhen, Guangdong 518040 (CN); XUE, Kangle, Shenzhen, Guangdong 518040 (CN); FAN, Yang, Shenzhen, Guangdong 518040 (CN); ZHOU, Guotong, Shenzhen, Guangdong 518040 (CN)
(74) Representative: Henselmann, Alexander Gerhard
(86) International application number: PCT/CN2025/074038
(87) International publication number: WO 2025/157189

(57) **Abstract**

Embodiments of this application provide an electronic device. The electronic device includes a charging interface, a first circuit board, a metal reinforcement member and a bracket assembly. The first circuit board includes a connection end. The connection end has a ground terminal. The connection end is electrically connected to the charging interface. The metal reinforcement member and the connection end are stacked. The metal reinforcement member is electrically connected to the ground terminal. The bracket assembly includes a metal bracket and a conductive member. At least part of the connection end is located in the metal bracket. The metal bracket includes a body portion and a ground portion. The ground portion is electrically connected to the body portion. The metal reinforcement member and the body portion are respectively electrically connected to the conductive member. The ground portion is configured to be grounded. The electronic device in the embodiments of this application helps reduce structural design difficulty, and reduce assembly difficulty and production costs.

## Description

This application claims priority to Chinese Patent Application No. 202410086776.3, filed with the China National Intellectual Property Administration on January 22, 2024 and entitled "ELECTRONIC DEVICE", which is incorporated herein by reference in its entirety.

### TECHNICAL FIELD

Embodiments of this application relate to the field of terminal technologies, and in particular, to an electronic device.

### BACKGROUND

With explosive growth of electronic devices such as a smartphone or a tablet computer, the electronic devices have increasingly more functions. During use of an electronic device, a battery in the electronic device needs to be charged, to ensure that a battery level in the battery meets an endurance capacity required for use by a user. The electronic device includes a charging interface. When the electronic device is charged, a charging head of a charger may be plugged to the charging interface, to charge the battery by the charger. Currently, to shorten a charging time, the battery is charged in a high-power fast charging manner. The charging interface is electrically connected to a circuit board. The circuit board may be electrically connected to a mainboard. The battery is electrically connected to the mainboard. The circuit board connected to the charging interface has a grounding requirement, to reduce a current loss of the circuit board. However, a grounding structure of the circuit board in the related art has a problem of affecting an internal structural design of the electronic device.

### SUMMARY

Embodiments of this application provide an electronic device, which is beneficial to reducing structural design difficulty, and reducing assembly difficulty and production costs.

An embodiment of this application provides an electronic device, including a charging interface, a first circuit board, a metal reinforcement member and a bracket assembly.

The first circuit board includes a connection end. The connection end has a ground terminal. The connection end is electrically connected to the charging interface. The metal reinforcement member and the connection end are stacked. The metal reinforcement member is electrically connected to the ground terminal. The bracket assembly includes a metal bracket and a conductive member. At least part of the connection end is located in the metal bracket. The metal bracket includes a body portion and a ground portion. The ground portion is electrically connected to the body portion. The metal reinforcement member and the body portion are respectively electrically connected to the conductive member. The ground portion is configured to be grounded.

In the electronic device of the embodiment of this application, the first circuit board connected to the charging interface includes a ground terminal. The first circuit board may be grounded by using the ground terminal. The ground terminal of the first circuit board may be electrically connected to the metal reinforcement member. The bracket assembly includes a metal bracket and a conductive member. The metal reinforcement member is electrically connected to the metal bracket by using the conductive member. The metal bracket includes a ground portion. The metal bracket is grounded by using the ground portion. A grounding path of the first circuit board may be the ground terminal, the metal reinforcement member, the conductive member, and the metal bracket. In this embodiment of this application, the metal reinforcement member is multiplexed, so that the metal reinforcement member may protect the first circuit board and may also be configured to transmit a grounding current. The metal bracket is also multiplexed, so that the metal bracket may support and fix a corresponding structural member, and may also be configured to transmit a grounding current. Therefore, in this embodiment of this application, a grounding structural design of the first circuit board may reduce the structural design difficulty and reduce the assembly difficulty and the production costs by multiplexing the corresponding structural member.

In a possible implementation, the metal reinforcement member is arranged between the body portion and the connection end. The conductive member is arranged between the metal reinforcement member and the body portion.

Internal space of the metal bracket may be multiplexed by the metal reinforcement member and the conductive member, to help reduce an occupancy rate of internal space of the electronic device by the metal reinforcement member and the conductive member in a thickness direction of the electronic device, which is beneficial to ensuring that a lightening and thinning design of the electronic device is implemented.

In a possible implementation, a concave portion is provided on at least one of the metal reinforcement member and the body portion. At least part of the conductive member is located in space formed by the concave portion.

The metal reinforcement member and the metal bracket may protect the conductive member, to reduce a possibility that the conductive member is impacted or collided.

In a possible implementation, a concave portion is provided on the body portion. The concave portion has an opening facing the metal reinforcement member. A surface of the metal reinforcement member facing the concave portion is a plane.

By providing the concave portion in the metal bracket, a structure for accommodating the conductive member does not need to be arranged on the metal reinforcement member, which is beneficial to implementing a flat design of the metal reinforcement member. That is, in the thickness direction of the electronic device, two opposite surfaces of the metal reinforcement member may be two flat surfaces, so that when the metal reinforcement member abuts against the connection end of the first circuit board, the metal reinforcement member does not apply a relatively large force on a part of the connection end, thereby avoiding a problem of structural damage caused by stress concentration on the connection end.

In a possible implementation, one of the metal reinforcement member and the body portion is welded to the conductive member, and the other abuts against the conductive member.

One of the metal reinforcement member and the body portion is welded to the conductive member, which is beneficial to ensuring stability and reliability of a connection between the conductive member and the one of the metal reinforcement member and the body portion, helping reduce a possibility of a grounding failure caused by a loss of contact between the conductive member and the one of the metal reinforcement member and the body portion. One of the metal reinforcement member and the body portion abuts against the conductive member, so that when the metal reinforcement member and the body portion are assembled, a tool does not need to be used to connect the one of the metal reinforcement member and the body portion and the conductive member. Therefore, after the metal reinforcement member and the body portion are assembled, communication between the metal reinforcement member, the conductive member, and the body portion may be implemented, helping reduce the assembly difficulty.

In a possible implementation, the conductive member is an elastic structural member. The metal reinforcement member and the body portion respectively apply a compressive stress to the conductive member.

When the conductive member is in a compressed state, the conductive member has an elastic restoring force, so that the conductive member may apply a reaction force to the metal reinforcement member and the body portion of the metal bracket. Therefore, the metal reinforcement member and the body portion of the metal bracket respectively maintain a good and stable contact state with the conductive member, helping reduce a possibility of a grounding failure or poor grounding caused by a poor connection between the metal reinforcement member and the conductive member and a poor connection between the body portion of the metal bracket and the conductive member.

In a possible implementation, the conductive member is a metal structural member. The conductive member includes a base body and an elastic foot. One of the metal reinforcement member and the body portion is connected to the base body, and the other is connected to the elastic foot.

Because the conductive member has rigidity, the metal reinforcement member and the body portion of the metal bracket are respectively in rigid contact with the conductive member. Therefore, contact statuses between the metal reinforcement member and the conductive member and between the body portion of the metal bracket and the conductive member are more stable, so that a radiated spurious emission (radiated spurious emission, RSE) phenomenon does not easily occur between the metal reinforcement member and the conductive member and between the body portion of the metal bracket and the conductive member, thereby reducing a possibility of generating an interference signal in a current transmission process.

In a possible implementation, one of the metal reinforcement member and the body portion is welded to the base body, and the other abuts against the elastic foot.

One of the metal reinforcement member and the body portion of the metal bracket is welded to the base body, which is beneficial to ensuring stability and reliability of a connection between the base body and the one of the metal reinforcement member and the body portion, helping reduce a possibility of a grounding failure caused by a loss of contact between the base body and the one of the metal reinforcement member and the body portion. Further, by using a welding manner, a connection component does not need to be additionally arranged. Additional arrangement of the connection component may cause the connection component to occupy more space in the thickness direction of the electronic device, affecting the lightening and thinning design of the electronic device. Therefore, by using the welding manner, the space can be saved in the thickness direction of the electronic device, which is beneficial to the lightening and thinning design of the electronic device.

One of the metal reinforcement member and the body portion abuts against the elastic foot, so that when the metal reinforcement member and the metal bracket are assembled, a tool does not need to be used to connect the one of the metal reinforcement member and the body portion and the elastic foot, helping reduce the assembly difficulty.

In a possible implementation, there are at least two elastic feet.

The at least two elastic feet may be both configured to transmit a grounding current, which effectively increases a quantity of grounding paths and is beneficial to dispersing the current, helping further reduce a current loss.

In a possible implementation, the conductive member is a metal elastic sheet.

When the metal reinforcement member, the conductive member and the metal bracket are assembled, the metal reinforcement member and the metal bracket jointly extrude the conductive member, so that the conductive member is flatter. Therefore, in the thickness direction of the electronic device, the conductive member may occupy relatively small space, which facilitates the lightening and thinning design of the electronic device.

In a possible implementation, the first circuit board is a flexible printed circuit board.

The first circuit board is flexible, and may be bent and folded after receiving a force, so that the first circuit board may be flexibly arranged inside the electronic device. A thickness of the first circuit board is relatively small, to conveniently pass through space between the battery and a battery cover, and occupy relatively small space in the thickness direction of the electronic device, thereby facilitating the lightening and thinning design of the electronic device.

In a possible implementation, the charging interface includes a ground pin. The ground terminal is electrically connected to the ground pin. The metal reinforcement member is electrically connected to the ground pin.

The charging interface may form a grounding path through the first circuit board, the metal reinforcement member, the conductive member, and the metal bracket, so that the metal reinforcement member and the metal bracket may be multiplexed to implement grounding of the charging interface, thereby reducing the grounding structural design difficulty, and reducing the assembly difficulty and the production costs.

In a possible implementation, the ground terminal includes a via hole and a metal pad. The metal pad is arranged in the via hole. The metal pad has a central through hole. The ground pin passes through the central through hole. The ground pin is welded to the metal pad.

The ground pin of the charging interface is welded to the metal pad, to ensure a stable and reliable connection between the ground pin of the charging interface and the metal pad, and space of the first circuit board in a thickness direction may be multiplexed by the ground pin of the charging interface, thereby reducing a space occupancy rate of the ground pin of the charging interface in the thickness direction.

In a possible implementation, the metal reinforcement member has an avoidance hole. The avoidance hole is provided corresponding to the central through hole of the metal pad. The ground pin passes through the avoidance hole. The ground pin is welded to the metal reinforcement member.

The ground pin of the charging interface is welded to the metal reinforcement member, so that the ground pin of the charging interface may apply an action force to the metal reinforcement member, and the metal reinforcement member abuts against the connection end of the first circuit board. The ground pin of the charging interface may be grounded, and may be connected to and fix the metal reinforcement member, so that the ground pin of the charging interface may be multiplexed. A position of the metal reinforcement member may be fixed by using the ground pin of the charging interface, and a connection structure does not need to be additionally arranged, thereby reducing structural design difficulty, reducing assembly difficulty and production costs, and occupying relatively small space inside the electronic device.

In a possible implementation, the electronic device further includes a metal middle frame. The ground portion is electrically connected to the metal middle frame. The ground portion is grounded by using the metal middle frame.

The first circuit board may form a grounding path by using the metal reinforcement member, the conductive member, the metal bracket, and the metal middle frame, so that the grounding path of the first circuit board is relatively short, which is beneficial to further reducing a current loss. The metal middle frame may implement a supporting function and a grounding function, so that the metal middle frame may be multiplexed, thereby reducing the structural design difficulty, and reducing the assembly difficulty and the production costs.

In a possible implementation, the electronic device further includes a conductive connection member. The ground portion is connected to the metal middle frame by using the conductive connection member.

The conductive connection member may ensure a stable and reliable connection between the ground portion of the metal bracket and the metal middle frame, and loosening does not easily occur between the metal bracket and the metal middle frame, helping reduce a possibility of a grounding failure or poor grounding caused by a poor connection between the ground portion of the metal bracket and the metal middle frame.

In a possible implementation, the conductive connection member includes a pressing portion and an adapter portion. The adapter portion is threadedly connected to the metal middle frame. The pressing portion abuts against the ground portion.

The adapter portion of the conductive connection member is threadedly connected to the metal middle frame, to facilitate assembly of the adapter portion and the metal middle frame, and ensure a stable connection state between the adapter portion and the metal middle frame.

The pressing portion of the conductive connection member abuts against the ground portion of the metal bracket. The pressing portion of the conductive connection member applies a compressive stress on the ground portion of the metal bracket, so that the pressing portion of the conductive connection member keeps a close contact state with the ground portion of the metal bracket, thereby ensuring a stable connection state.

In a possible implementation, the metal bracket includes a convex portion. The convex portion protrudes toward the metal middle frame. The convex portion forms the ground portion. The pressing portion abuts against a surface of the convex portion facing away from the metal middle frame.

In a possible implementation, the electronic device further includes a second circuit board. The second circuit board is located inside the metal bracket. The metal bracket forms a limitation to the second circuit board. The ground portion is electrically connected to the second circuit board. The ground portion is grounded by using the second circuit board.

The second circuit board may implement a component mounting function and a grounding function, so that the second circuit board may be multiplexed, thereby reducing the grounding structural design difficulty, and reducing the assembly difficulty and the production costs.

In a possible implementation, the electronic device further includes a second circuit board, a battery, and a mainboard. The battery is arranged between the second circuit board and the mainboard. The battery is arranged on a side of the first circuit board. The first circuit board is electrically connected to the mainboard.

In a possible implementation, the electronic device further includes a metal middle frame. The second circuit board is connected to the metal middle frame. The second circuit board is a printed circuit board.

In a possible implementation, an insulator is arranged on a surface of the body portion facing the metal reinforcement member.

The body portion of the metal bracket and the metal reinforcement member are in a non-electrically connected state, that is, in a mutually insulated state, thereby avoiding a problem that a signal transmitted on the first circuit board is interfered caused by connection between the metal bracket and the metal reinforcement member.

### BRIEF DESCRIPTION OF DRAWINGS

FIG. 1 is a schematic structural diagram of an electronic device according to an embodiment of this application;
FIG. 2 is a partial schematic exploded structural view of an electronic device according to an embodiment of this application;
FIG. 3 is a partial schematic structural diagram of an electronic device according to an embodiment of this application;
FIG. 4 is a partial schematic exploded structural view of an electronic device according to an embodiment of this application;
FIG. 5 is a partial schematic structural diagram of a first circuit board according to an embodiment of this application;
FIG. 6 is a partial schematic structural diagram of a bracket assembly according to an embodiment of this application;
FIG. 7 is a partial schematic cross-sectional structural view of an electronic device according to an embodiment of this application;
FIG. 8 is a schematic enlarged view of a position M in FIG. 7;
FIG. 9 is a partial schematic exploded structural view of an electronic device according to an embodiment of this application;
FIG. 10 is a partial schematic cross-sectional structural view of an electronic device according to an embodiment of this application; and
FIG. 11 is a schematic enlarged view of a position W in FIG. 7.

Reference numerals:
10: Electronic device;
20: Display screen;
30: Housing; 31: Metal middle frame; 311: Outer frame; 312: Middle plate; 32: Battery cover;
40: Mainboard;
50: Electronic component;
60: Battery;
70: First circuit board; 71: Connection end; 711: Ground terminal; 711a: Via hole; 711b: Metal pad;
80: Second circuit board;
90: Charging interface; 91: Ground pin;
100: Bracket assembly; 110: Metal bracket; 111: Body portion; 112: Ground portion; 120: Conductive member; 121: Base body; 122: Elastic foot;
200: Metal reinforcement member; 210: Avoidance hole;
300: Concave portion;
400: Conductive connection member; 410: Pressing portion; 420: Adapter portion; and
Z: Thickness direction.

### DESCRIPTION OF EMBODIMENTS

An electronic device in embodiments of this application may be referred to as a user equipment (user equipment, UE), a terminal (terminal), or the like. For example, the electronic device may be a mobile terminal or a fixed terminal like a portable android device (portable android device, PAD), a personal digital assistant (personal digital assistant, PDA), a handheld device having a wireless communication function, a computing device, an in-vehicle device, a wearable device, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of a terminal device is not specifically limited in embodiments of this application.

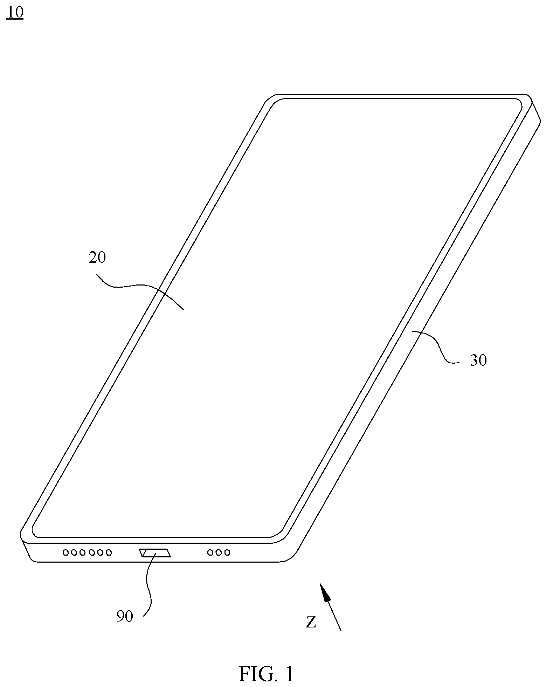

In the embodiments of this application, an example in which the electronic device is a handheld device having a wireless communication function is used for description. For example, the handheld device having a wireless communication function may be a straight-screen mobile phone or a foldable mobile phone. FIG. 1 schematically shows a structure of an electronic device 10. Referring to FIG. 1, for example, the handheld device having a wireless communication function may be a straight-screen mobile phone.

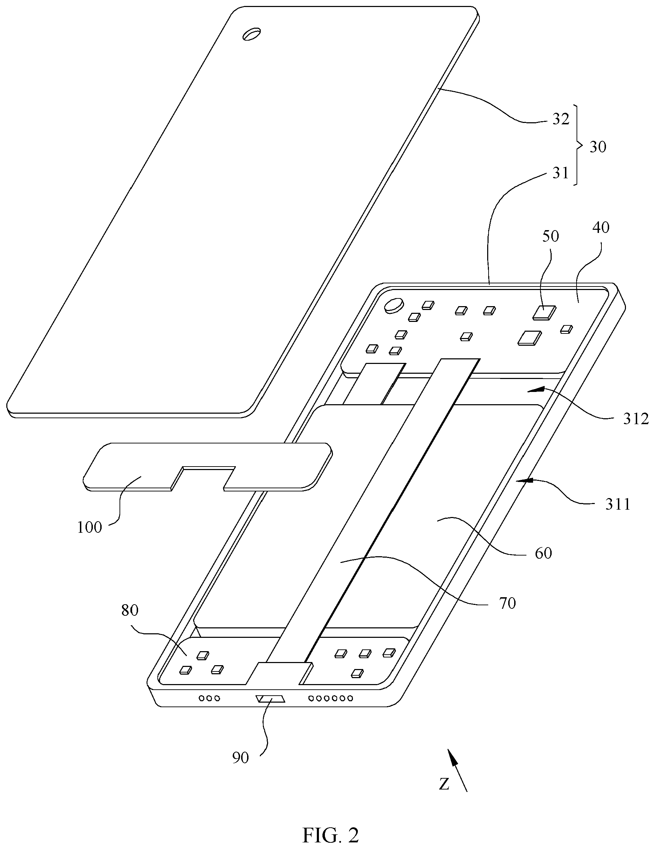

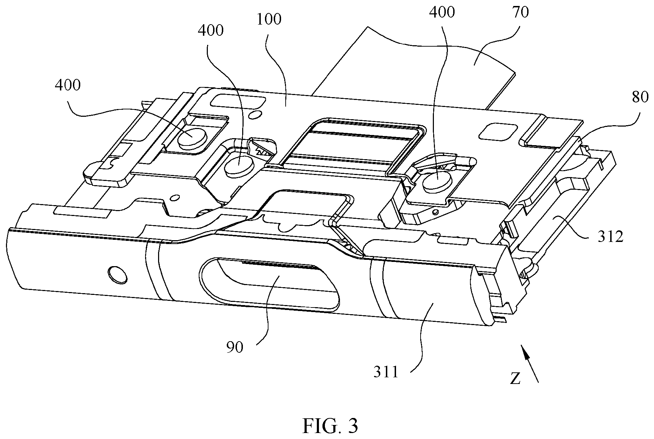

FIG. 2 schematically shows a partial exploded structure of the electronic device 10. FIG. 3 schematically shows a partial structure of the electronic device 10. Referring to FIG. 1 to FIG. 3, the electronic device 10 in the embodiments of this application may include a display assembly, a housing 30, a mainboard 40, an electronic component 50, a battery 60, a first circuit board 70, a second circuit board 80, and a charging interface 90.

The display assembly includes a display screen 20 which is configured to display image information. The display assembly is mounted on the housing 30, and a display region of the display screen 20 may be configured to present image information to a user. The housing 30 may include a metal middle frame 31 and a battery cover 32. The display assembly is connected to the metal middle frame 31. For example, the display assembly may be bonded to the metal middle frame 31. A material of the metal middle frame 31 may be, but is not limited to, aluminum, aluminum alloy, steel, or titanium alloy.

The mainboard 40 and the battery 60 may be arranged inside the electronic device 10, and are located on inner sides of the housing 30 and the display assembly, so that the user is less likely to observe the mainboard 40 and the battery 60 from the outside of the electronic device 10. The battery 60 may be arranged between the metal middle frame 31 and the battery cover 32. The battery cover 32 shields the battery 60. The battery 60 is configured to supply electrical energy to the electronic device 10 to ensure normal operation of the electronic device 10. For example, the battery 60 may supply electrical energy to the display assembly, so that the display assembly displays image information or completes corresponding operation instructions. Alternatively, the battery 60 may supply electrical energy to the mainboard 40, to ensure normal operation of the electronic component 50 on the mainboard 40. The battery 60 may be a lithium ion battery, for example, a lithium iron phosphate battery.

The electronic component 50 is arranged on the mainboard 40. The mainboard 40 may be a printed circuit board (printed circuit board, PCB). The electronic component 50 is welded to the mainboard 40 by using a welding process. The electronic component 50 includes, but is not limited to, a central processing unit (central processing unit, CPU), an intelligent algorithm chip, or a power management integrated chip (power management IC, PMIC).

The first circuit board 70 and the second circuit board 80 are arranged inside the electronic device 10. The battery 60 may be arranged between the mainboard 40 and the second circuit board 80. A charging circuit is arranged on the mainboard 40. The charging circuit has an input end and an output end. The first circuit board 70 is electrically connected to the input end of the charging circuit. The output end of the charging circuit is electrically connected to the battery 60. When the battery 60 of the electronic device 10 is charged by using an external charging apparatus (for example, a charger), the first circuit board 70 may be configured to transmit a charging current.

The second circuit board 80 may be used as a secondary board. In an embodiment in which the second circuit board 80 is used as a secondary board, an area of the mainboard 40 is relatively larger than an area of the second circuit board 80, so that more electronic components 50 may be arranged on the mainboard 40.

In some examples, the first circuit board 70 may be a flexible printed circuit board (flexible printed circuit board, FPCB). The second circuit board 80 may be a printed circuit board.

The electronic device 10 further includes a charging interface 90. The charging interface 90 may be arranged in the metal middle frame 31. The first circuit board 70 connects the charging interface 90 and the mainboard 40. The charging interface 90 may be electrically connected to the input end of the charging interface by using the first circuit board 70 and the mainboard 40. During charging of the battery 60 of the electronic device 10, an electrical signal may be inputted from the charging interface 90, and reaches the charging circuit through the first circuit board 70 and the mainboard 40. After performing boost conversion or buck conversion on the inputted electrical signal, the charging circuit outputs the electrical signal to the battery 60 by using the mainboard 40. The electrical signal enters the battery 60 and is stored, to achieve an objective of energy storage. During discharging of the battery 60 of the electronic device 10, an electrical signal outputted by the battery 60 may be outputted to the mainboard 40, to supply electrical energy to the mainboard 40.

In some examples, the charging interface 90 may be a USB Type-C interface, a Micro USB interface, or a lightning (lightning) interface.

The electronic device 10 further includes a bracket assembly 100. In internal space of the electronic device 10, the bracket assembly 100 may be configured to support and fix the second circuit board 80, to ensure stability of a position of the second circuit board 80, and also ensure stability of a position of the charging interface 90. When the electronic device 10 receives an impact force, the position of the second circuit board 80 and the position of the charging interface 90 are not easily offset. In some examples, the bracket assembly 100 may be connected to the metal middle frame 31, to fix a position of the bracket assembly 100. The second circuit board 80 may be located inside the bracket assembly 100.

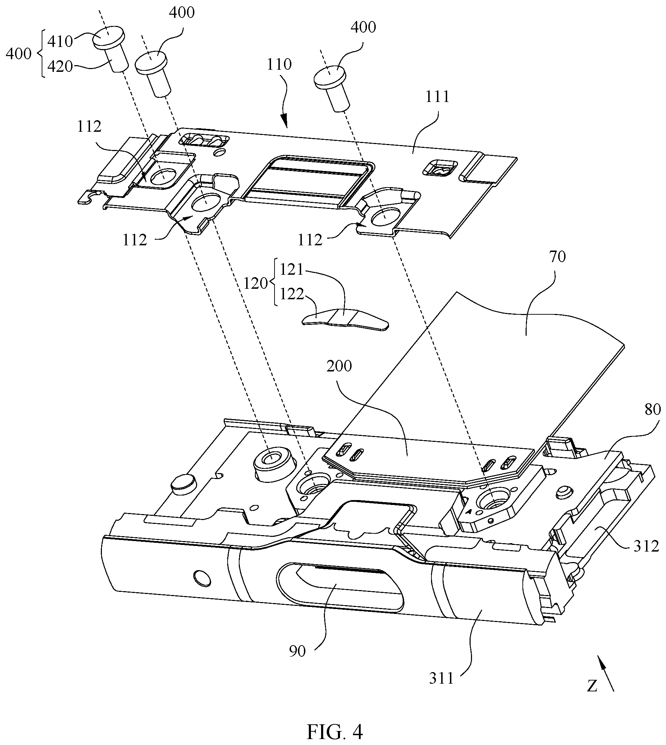

FIG. 4 schematically shows a partial exploded structure of the electronic device 10. As shown in FIG. 4, the electronic device 10 further includes a metal reinforcement member 200. The metal reinforcement member 200 is connected to the first circuit board 70. The metal reinforcement member 200 may protect a corresponding region of the first circuit board 70, which is beneficial to reducing a possibility of structural damage to the corresponding region of the first circuit board 70 under external pressure. In some examples, the metal reinforcement member 200 may be a metal plate, which is beneficial to reducing a thickness of the metal reinforcement member 200 and reducing a space occupancy rate. A material of the metal reinforcement member 200 may be, but is not limited to, steel, aluminum, or aluminum alloy.

In the related art, in order to effectively reduce a current flowing through the first circuit board during a charging process to reduce a current loss, the first circuit board in the electronic device needs to be grounded. The first circuit board includes a main circuit and a branch circuit. The main circuit of the first circuit board is configured to be electrically connected to the charging interface and the mainboard. The first circuit board may be grounded by using the additionally arranged branch circuit. A bifurcated structural design of the first circuit board leads to relatively high structural design difficulty and processing difficulty of the first circuit board, and consequently, costs of the first circuit board are relatively high. In addition, the bifurcated structural design of the first circuit board occupies relatively more space. To adapt to the bifurcated structural design of the first circuit board, another structural member inside the electronic device needs to be adaptively adjusted. Therefore, a grounding structural design of the first circuit board may cause an adverse effect on a structural design of an internal component of the electronic device.

According to the electronic device 10 provided in the embodiments of this application, the first circuit board 70 may be grounded by using the bracket assembly 100 located in the internal space of the electronic device 10, so that the bracket assembly 100 is multiplexed, and the bracket assembly 100 implements a supporting and fixing function and a grounding function, which is beneficial to reducing structural design difficulty, and reducing assembly difficulty and production costs.

An implementation of the electronic device 10 provided in the embodiments of this application is described below.

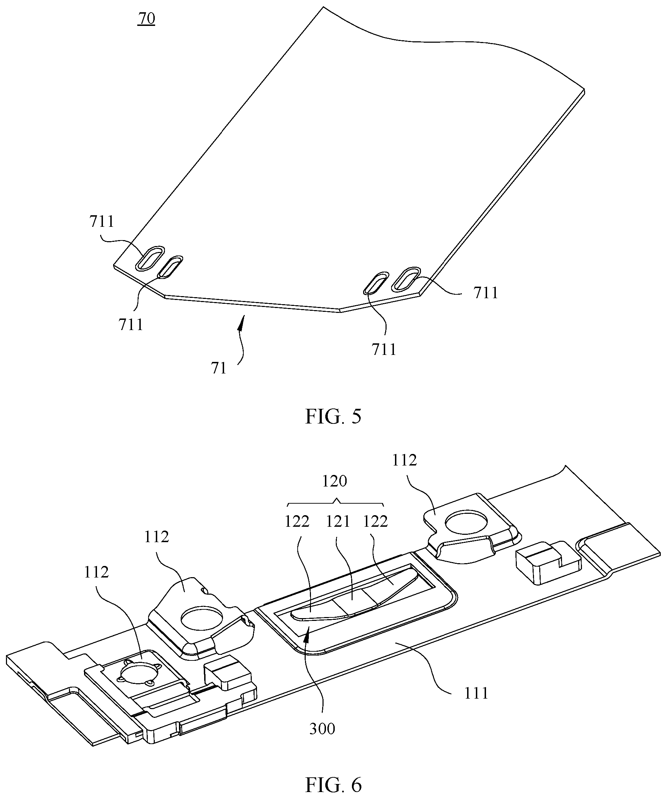

FIG. 5 schematically shows a partial structure of the first circuit board 70. Referring to FIG. 4 and FIG. 5, the first circuit board 70 in the embodiments of this application includes a connection end 71. An end portion of the first circuit board 70 close to the charging interface 90 forms the connection end 71. An end portion of the first circuit board 70 close to the mainboard 40 is electrically connected to the mainboard 40. The connection end 71 has a ground terminal 711. The first circuit board 70 may be grounded by using the ground terminal 711. The connection end 71 of the first circuit board 70 is electrically connected to the charging interface 90.

The charging interface 90 has a plurality of pins. The connection end 71 has a plurality conductive sheets. Each conductive sheet may be electrically connected to a corresponding pin. When the charging interface 90 is plugged to an external charging device for charging, a current at the charging interface 90 may be transmitted to the first circuit board 70 by using the connection end 71.

In the embodiments of this application, the metal reinforcement member 200 and the connection end 71 of the first circuit board 70 are stacked. The metal reinforcement member 200 may be arranged on a side of the connection end 71 facing the battery cover 32. At least part of the connection end 71 is located below the metal reinforcement member 200. The connection end 71 may be in contact with and attached to the metal reinforcement member 200. The metal reinforcement member 200 has relatively high rigidity and deformation resistance. The metal reinforcement member 200 may protect the connection end 71, and reduce a possibility of structural damage such as tearing or cracking to the connection end 71 under an external compressive stress. The metal reinforcement member 200 is electrically connected to the ground terminal 711 of the connection end 71. Therefore, the metal reinforcement member 200 may be multiplexed, so that the metal reinforcement member 200 has a protection function and a connection function.

In some examples, the ground terminal 711 may be welded to the metal reinforcement member 200.

In some examples, the metal reinforcement member 200 is an integrally formed structure. The metal reinforcement member 200 may be a metal plate. In the embodiments of this application, a shape of the metal reinforcement member 200 is not specifically limited, as long as the shape of the metal reinforcement member 200 can effectively cover the connection end 71.

In the embodiments of this application, the bracket assembly 100 includes a metal bracket 110. The metal bracket 110 may increase overall rigidity of the bracket assembly 100. In addition, when it is ensured that the bracket assembly 100 satisfies a rigidity requirement, a thickness of the metal bracket 110 is relatively small, which is beneficial to reducing a volume of the bracket assembly 100 and reducing a space occupancy rate of the bracket assembly 100. The bracket assembly 100 may further include an insulating structure. The insulating structure is connected to the metal bracket 110. The insulating structure is configured to be arranged corresponding to a component which is relatively sensitive to a metal structural member, to reduce interference. At least part of the connection end 71 is located inside the metal bracket 110, so that the metal bracket 110 may protect the connection end 71. The metal bracket 110 includes a body portion 111 and a ground portion 112. The ground portion 112 is electrically connected to the body portion 111. The ground portion 112 of the metal bracket 110 is configured to be grounded.

In some examples, a material of the metal bracket 110 may be, but is not limited to, steel, aluminum, or aluminum alloy. The bracket assembly 100 may be connected to the metal middle frame 31. For example, both the metal bracket 110 and the insulating structure of the bracket assembly 100 may be both configured to be connected to the metal middle frame 31.

In some examples, the metal bracket 110 may be an integrally formed structure. For example, the metal bracket 110 may be formed by a sheet blank through a stamping process.

In the embodiments of this application, the bracket assembly 100 further includes a conductive member 120. The conductive member 120 has good conductivity. The metal reinforcement member 200 and the body portion 111 of the metal bracket 110 are respectively electrically connected to the conductive member 120. Used as a transition connection member, the conductive member 120 may connect the metal reinforcement member 200 to the metal bracket 110. Because the metal reinforcement member 200 is electrically connected to the ground terminal 711 of the first circuit board 70, the metal bracket 110 may be electrically connected to the ground terminal 711 of the first circuit board 70 by using the conductive member 120 and the metal reinforcement member 200. In the embodiments of this application, the ground terminal 711 of the first circuit board 70 is grounded by using the metal reinforcement member 200, the conductive member 120, and the ground portion 112 of the metal bracket 110.

In the electronic device 10 of the embodiments of this application, the first circuit board 70 connected to the charging interface 90 includes the ground terminal 711. The first circuit board 70 may be grounded by using the ground terminal 711. The ground terminal 711 of the first circuit board 70 may be electrically connected to the metal reinforcement member 200. The bracket assembly 100 includes the metal bracket 110 and the conductive member 120. The metal reinforcement member 200 is electrically connected to the metal bracket 110 by using the conductive member 120. The metal bracket 110 includes the ground portion 112. The metal bracket 110 is grounded by using the ground portion 112. A grounding path of the first circuit board 70 may be the ground terminal 711, the metal reinforcement member 200, the conductive member 120, and the metal bracket 110. In the embodiments of this application, the metal reinforcement member 200 is multiplexed, so that the metal reinforcement member 200 may protect the first circuit board 70 and may also be configured to transmit a grounding current. The metal bracket 110 is also multiplexed, so that the metal bracket 110 may support and fix a corresponding structural member, and may also be configured to transmit a grounding current. Therefore, in the embodiments of this application, the grounding structural design of the first circuit board 70 may reduce the structural design difficulty and reduce the assembly difficulty and the production costs by multiplexing a corresponding structural member.

The metal reinforcement member 200 in the embodiments of this application may be arranged between the body portion 111 of the metal bracket 110 and the connection end 71 of the first circuit board 70. The conductive member 120 is arranged between the metal reinforcement member 200 and the body portion 111 of the metal bracket 110. In a thickness direction Z of the electronic device 10, the connection end 71 of the first circuit board 70, the metal reinforcement member 200, and the body portion 111 of the metal bracket 110 are stacked. The thickness direction Z of the electronic device 10 may be the same as a thickness direction of the display screen 20. The connection end 71 of the first circuit board 70 may be located on a side of the metal reinforcement member 200 facing the display screen 20. The metal reinforcement member 200 may be located on a side of the body portion 111 of the metal bracket 110 facing the display screen 20. The conductive member 120 may be located on the side of the body portion 111 of the metal bracket 110 facing the display screen 20.

Internal space of the metal bracket 110 may be multiplexed by using the metal reinforcement member 200 and the conductive member 120, helping reduce an occupancy rate of the internal space of the electronic device 10 by the metal reinforcement member 200 and the conductive member 120 in the thickness direction Z of the electronic device 10, which is beneficial to ensuring that the lightening and thinning design of the electronic device 10 is implemented.

A concave portion is provided on at least one of the metal reinforcement member 200 and the body portion 111 of the metal bracket 110. At least part of the conductive member 120 is located in space formed by the concave portion. When the metal reinforcement member 200 and the body portion 111 of the metal bracket 110 are stacked, mounting space may be formed by the concave portion between the metal reinforcement member 200 and the metal bracket 110, to arrange the conductive member 120 in the space. The metal reinforcement member 200 and the metal bracket 110 may protect the conductive member 120, to reduce a possibility that the conductive member 120 is impacted or collided.

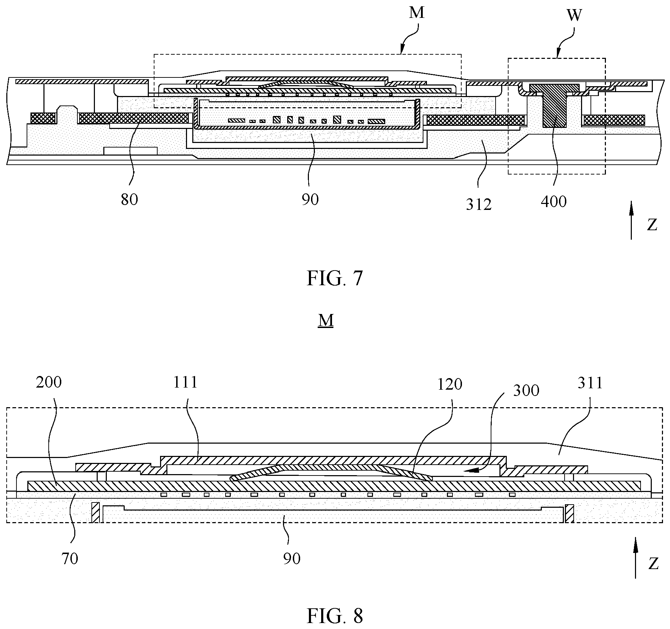

In some examples, FIG. 6 schematically shows a partial structure of the bracket assembly 100. FIG. 7 schematically shows a partial cross-sectional structure of the electronic device 10. FIG. 8 is an enlarged diagram of a position M in FIG. 7. Referring to FIG. 6, FIG. 7, and FIG. 8, the concave portion 300 is provided on the body portion 111 of the metal bracket 110. The concave portion 300 has an opening facing the metal reinforcement member 200. The conductive member 120 is located in the space formed by the concave portion 300. For example, in the thickness direction Z of the electronic device 10, a gap between a bottom wall of the concave portion 300 and a surface of the metal reinforcement member 200 may be greater than or equal to 0.2 mm (mm), which is beneficial to ensuring that the arranged conductive member 120 occupies relatively small space in the thickness direction Z of the electronic device 10, to facilitate an implementation of the lightening and thinning design of the electronic device 10.

For example, a surface of the metal reinforcement member 200 facing the concave portion 300 is a plane. A surface of the metal reinforcement member 200 facing the connection end 71 is a plane.

By providing the concave portion 300 on the metal bracket 110, a structure for accommodating the conductive member 120 does not need to be arranged on the metal reinforcement member 200, which is beneficial to implementing a flat design of the metal reinforcement member 200. That is, in the thickness direction Z of the electronic device 10, two opposite surfaces of the metal reinforcement member 200 may be two flat surfaces, so that when the metal reinforcement member 200 abuts against the connection end 71 of the first circuit board 70, the metal reinforcement member 200 does not apply a relatively large action force on a part of the connection end 71, thereby avoiding a problem of structural damage caused by stress concentration on the connection end 71.

In some examples, the concave portion 300 is provided on the metal reinforcement member 200. The conductive member 120 is located in the space formed by the concave portion 300. For example, in the thickness direction Z of the electronic device 10, a gap between the bottom wall of the concave portion 300 and a surface of the body portion 111 may be greater than or equal to 0.2 mm (mm).

In some examples, the concave portions 300 are provided on the metal reinforcement member 200 and the body portion 111 of the metal bracket 110. The entire conductive member 120 is located in the space formed by the concave portion 300. For example, in the thickness direction Z of the electronic device 10, a gap between bottom walls of two concave portions 300 may be greater than or equal to 0.2 mm (mm).

In the embodiments of this application, the body portion 111 of the metal bracket 110 may be connected to the conductive member 120. For example, the metal bracket 110 and the conductive member 120 may be an integrally formed structure. Alternatively, the metal bracket 110 and the conductive member 120 may be separately processed and manufactured, and then assembled to implement a connection. The metal reinforcement member 200 may be connected to the conductive member 120 or abut against the conductive member 120. It should be noted that, abutment refers to that two structural members are in a contact state and apply a compressive stress on each other.

In the embodiments of this application, the metal reinforcement member 200 may also be connected to the conductive member 120. For example, the metal reinforcement member 200 and the conductive member 120 may be an integrally formed structure. Alternatively, the metal reinforcement member 200 and the conductive member 120 may be separately processed and manufactured, and then assembled to implement a connection. The metal bracket 110 may be connected to the conductive member 120 or abut against the conductive member 120.

In some possible implementations, one of the metal reinforcement member 200 and the body portion 111 of the metal bracket 110 is welded to the conductive member 120, and the other abuts against the conductive member 120. One of the metal reinforcement member 200 and the body portion 111 is welded to the conductive member 120, which is beneficial to ensuring stability and reliability of a connection between the conductive member 120 and the one of the metal reinforcement member 200 and the body portion 111, helping reduce a possibility of a ground failure caused by a loss of contact between the conductive member 120 and the one of the metal reinforcement member 200 and the body portion 111. One of the metal reinforcement member 200 and the body portion 111 abuts against the conductive member 120, so that when the metal reinforcement member 200 and the body portion 111 are assembled, a tool does not need to be used to connect the one of the metal reinforcement member 200 and the body portion 111 and the conductive member 120. Therefore, after the metal reinforcement member 200 and the body portion 111 are assembled, a connection between the metal reinforcement member 200, the conductive member 120, and the body portion 111 may be implemented, helping reduce assembly difficulty.

In some examples, the metal reinforcement member 200 is welded to the conductive member 120, and the body portion 111 of the metal bracket 110 abuts against the conductive member 120.

In some examples, the body portion 111 of the metal bracket 110 is welded to the conductive member 120, and the metal reinforcement member 200 abuts against the conductive member 120.

In the embodiments of this application, the conductive member 120 may be an elastic structural member. The conductive member 120 may be deformed under an external force. The metal reinforcement member 200 and the body portion 111 of the metal bracket 110 may respectively apply a compressive stress to the conductive member 120. When the conductive member 120 is in a compressed state, the conductive member 120 has an elastic restoring force, so that the conductive member 120 may apply a reaction force to the metal reinforcement member 200 and the body portion 111 of the metal bracket 110. Therefore, the metal reinforcement member 200 and the body portion 111 of the metal bracket 110 respectively maintain a good and stable contact state with the conductive member 120, helping reduce a possibility of a grounding failure or poor grounding caused by a poor connection between the metal reinforcement member 200 and the conductive member 120 and a poor connection between the body portion 111 of the metal bracket 110 and the conductive member 120.

In addition, the conductive member 120 may be deformed in the thickness direction Z of the electronic device 10, so that a space occupancy rate of the conductive member 120 in the thickness direction Z of the electronic device 10 may also be reduced.

In some examples, the conductive member 120 is a flexible structural member. In a force-bearing state of the conductive member 120, the conductive member 120 may be deformed in a force-bearing region. The metal reinforcement member 200 and the body portion 111 of the metal bracket 110 may respectively abut against the conductive member 120. Alternatively, one of the metal reinforcement member 200 and the body portion 111 may be bonded to the conductive member 120, and the other may abut against the conductive member 120. For example, the conductive member 120 may be conductive foam.

In some examples, the conductive member 120 is a metal structural member. The conductive member 120 is a rigid structural member. The conductive member 120 may be deformed correspondingly by being jointly extruded by the metal reinforcement member 200 and the body portion 111 of the metal bracket 110. Because the conductive member 120 has rigidity, the metal reinforcement member 200 and the body portion 111 of the metal bracket 110 are respectively in rigid contact with the conductive member 120. Therefore, contact statuses between the metal reinforcement member 200 and the conductive member 120 and between the body portion 111 of the metal bracket 110 and the conductive member 120 are more stable, so that a radiated spurious emission (radiated spurious emission, RSE) phenomenon does not easily occur between the metal reinforcement member 200 and the conductive member 120 and between the body portion 111 of the metal bracket 110 and the conductive member 120, thereby reducing a possibility of generating an interference signal in a current transmission process.

For example, referring to FIG. 6 and FIG. 8, the conductive member 120 includes a base body 121 and an elastic foot 122. One of the metal reinforcement member 200 and the body portion 111 of the metal bracket 110 is connected to the base body 121, and the other is connected to the elastic foot 122. When a force is applied to the elastic foot 122, the elastic foot 122 may move relative to the base body 121, so that the conductive member 120 is deformed correspondingly. When the metal reinforcement member 200, the conductive member 120, and the body portion 111 of the metal bracket 110 are assembled, the metal reinforcement member 200 and the body portion 111 of the metal bracket 110 jointly extrude the conductive member 120, so that the elastic foot 122 is deformed and accumulates elastic potential energy.

For example, one of the metal reinforcement member 200 and the body portion 111 of the metal bracket 110 is welded to the base body 121, and the other abuts against the elastic foot 122.

One of the metal reinforcement member 200 and the body portion 111 of the metal bracket 110 is welded to the base body 121, which is beneficial to ensuring stability and reliability of a connection between the base body 121 and the one of the metal reinforcement member 200 and the body portion 111, helping reduce a possibility of a grounding failure caused by a loss of contact between the base body 121 and the one of the metal reinforcement member 200 and the body portion 111. Further, by using a welding manner, a connection component does not need to be additionally arranged. Additional arrangement of the connection component may cause the connection component to occupy more space in the thickness direction Z of the electronic device 10, affecting the lightening and thinning design of the electronic device 10. Therefore, by using the welding manner, the space can be saved in the thickness direction Z of the electronic device 10, which is beneficial to the lightening and thinning design of the electronic device 10.

One of the metal reinforcement member 200 and the body portion 111 abuts against the elastic foot 122, so that when the metal reinforcement member 200 and the metal bracket 110 are assembled, a tool does not need to be used to connect the one of the metal reinforcement member 200 and the body portion 111 and the elastic foot 122, helping reduce assembly difficulty. For example, in a process in which the metal reinforcement member 200 and the body portion 111 of the metal bracket 110 jointly extrude the conductive member 120, the elastic foot 122 may slide relative to one of the metal reinforcement member 200 and the body portion 111.

In some examples, the body portion 111 of the metal bracket 110 is welded to the base body 121, and the metal reinforcement member 200 abuts against the elastic foot 122. There is a gap between the metal reinforcement member 200 and the base body 121 of the conductive member 120, to ensure that the base body 121 is not in contact with the metal reinforcement member 200.

In some examples, the metal reinforcement member 200 is welded to the base body 121, and the body portion 111 of the metal bracket 110 abuts against the elastic foot 122. There is a gap between the base body 121 of the conductive member 120 and the body portion 111 of the metal bracket 110, to ensure that the base body 121 is not in contact with the body portion 111 of the metal bracket 110.

In some examples, the base body 121 of conductive member 120 and the elastic foot 122 are an integrally formed structure.

In the embodiments of this application, there may be one elastic foot 122.

In the embodiments of this application, there may be at least two elastic feet 122. A grounding current on the first circuit board 70 may be transmitted to the metal bracket 110 by using the metal reinforcement member 200, the at least two elastic feet 122, and the base body 121. Then, the ground current is grounded through the ground portion 112 of the metal bracket 110. The at least two elastic feet 122 may be both configured to transmit the grounding current, which effectively increases a quantity of grounding paths and is beneficial to dispersing the current, helping further reduce a current loss. The at least two elastic feet 122 are arranged at intervals around the base body 121.

In some examples, there may be two, three, or four elastic feet 122, which is not specifically limited in the embodiments of this application.

In some examples, a width of the elastic foot 122 gradually decreases along a direction away from the base body 121. An end portion of the elastic foot 122 away from the base body 121 may be an arc-shaped structure.

In the embodiments of this application, the conductive member 120 may be a metal elastic sheet. A material of the conductive member 120 may be, but is not limited to, copper, copper alloy, steel, aluminum, or aluminum alloy. The elastic foot 122 is arranged to intersect with the base body 121, so that the elastic foot 122 is in a tilted state relative to the base body 121. When the metal reinforcement member 200, the conductive member 120, and the metal bracket 110 are assembled, the metal reinforcement member 200 and the metal bracket 110 jointly extrude the conductive member 120, so that the conductive member 120 is flatter. Therefore, in the thickness direction Z of the electronic device 10, the conductive member 120 may occupy relatively small space, which facilitates the lightening and thinning design of the electronic device 10.

In the embodiments of this application, the first circuit board 70 is a flexible printed circuit board. The first circuit board 70 is flexible, and may be bent and folded after receiving a force, so that the first circuit board 70 may be flexibly arranged inside the electronic device 10. A thickness of the first circuit board 70 is relatively small, to conveniently pass through space between the battery 60 and the battery cover 32, and occupy relatively small space in the thickness direction Z of the electronic device 10, thereby facilitating the lightening and thinning design of the electronic device 10. The metal reinforcement member 200 and the connection end 71 of the first circuit board 70 are stacked along a thickness direction of the first circuit board 70, so that the connection end 71 is shielded by the metal reinforcement member 200. Therefore, the connection end 71 can be effectively protected by the metal reinforcement member 200. The metal reinforcement member 200 is arranged on a side of the connection end 71 facing the battery cover 32. The thickness direction of the first circuit board 70 may be the same as the thickness direction Z of the electronic device 10.

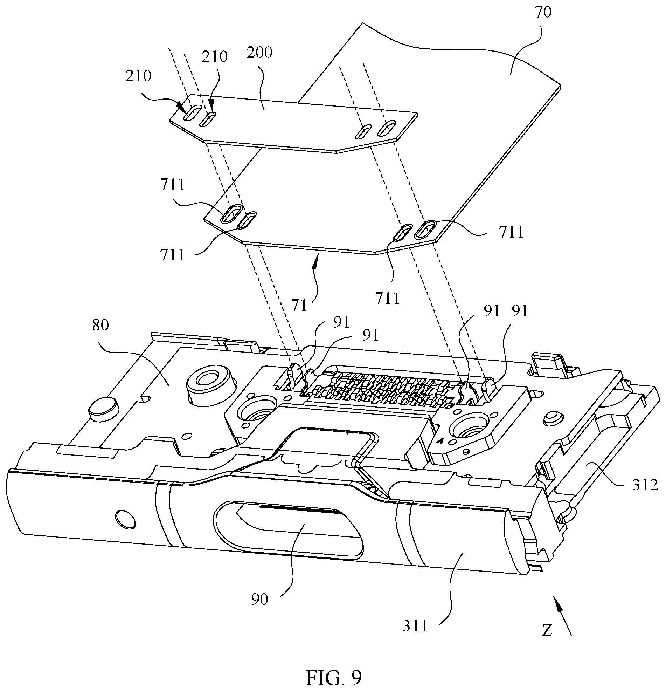

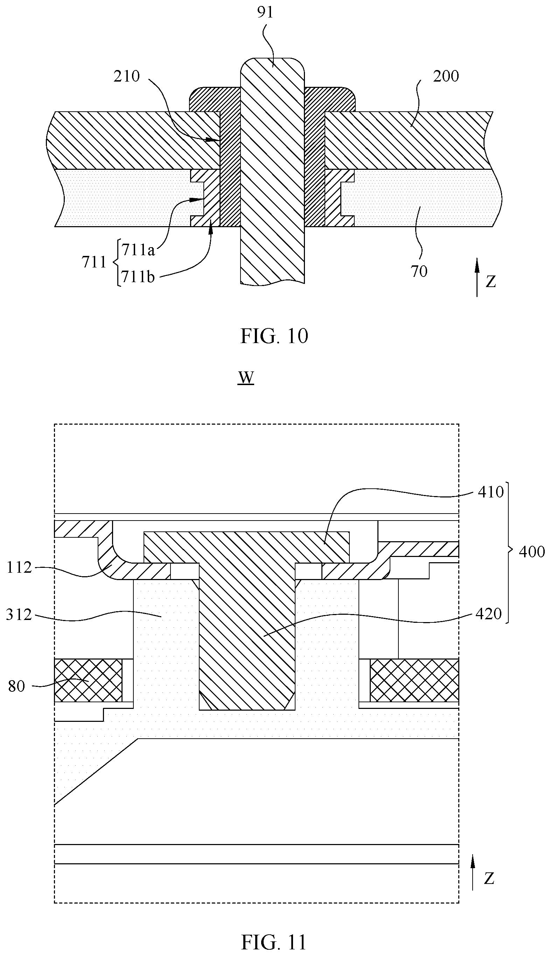

In the embodiments of this application, FIG. 9 schematically shows a partial exploded structure of the electronic device 10. FIG. 10 schematically shows a partial cross-sectional structure of the electronic device 10. As shown in FIG. 9 and FIG. 10, the charging interface 90 includes a ground pin 91. The charging interface 90 may be grounded by using the ground pin 91, to effectively increase safety when the charging interface 90 is used for charging. The ground terminal 711 of the first circuit board 70 is electrically connected to the ground pin 91 of the charging interface 90. The metal reinforcement member 200 is electrically connected to the ground pin 91 of the charging interface 90. The charging interface 90 may form a grounding path by using the first circuit board 70, the metal reinforcement member 200, the conductive member 120, and the metal bracket 110, so that the metal reinforcement member 200 and the metal bracket 110 may be multiplexed to implement grounding of the charging interface 90, thereby reducing grounding structural design difficulty, and reducing assembly difficulty and production costs.

In some examples, the ground terminal 711 of the first circuit board 70 includes a via hole 711a and a metal pad 711b. The metal pad 711b is arranged in the via hole 711a. The metal pad 711b has a central through hole. The ground pin 91 of the charging interface 90 passes through the central through hole of the metal pad 711b. The ground pin 91 of the charging interface 90 is welded to the metal pad 711b, to ensure a stable and reliable connection between the ground pin 91 of the charging interface 90 and the metal pad 711b, and space of the first circuit board 70 in the thickness direction may be multiplexed by the ground pin 91 of the charging interface 90, thereby reducing a space occupancy rate of the ground pin 91 of the charging interface 90 in the thickness direction.

In some examples, the metal reinforcement member 200 may be electrically connected to the metal pad 711b. The metal reinforcement member 200 has an avoidance hole 210. The avoidance hole 210 of the metal reinforcement member 200 is provided corresponding to the central through hole of the metal pad 711b. The ground pin 91 of the charging interface 90 passes through the avoidance hole 210 of the metal reinforcement member 200. The ground pin 91 of the charging interface 90 sequentially passes through the first circuit board 70 and the metal reinforcement member 200. The ground pin 91 of the charging interface 90 is welded to the metal reinforcement member 200, so that the ground pin 91 of the charging interface 90 may apply an action force to the metal reinforcement member 200, and the metal reinforcement member 200 abuts against the connection end 71 of the first circuit board 70. The metal reinforcement member 200 may be electrically connected to the metal pad 711b by using the ground pin 91. The ground pin 91 of the charging interface 90 may implement a grounding function, and may be connected to and fix the metal reinforcement member 200, so that the ground pin 91 of the charging interface 90 may be multiplexed. A position of the metal reinforcement member 200 may be fixed by using the ground pin 91 of the charging interface 90, and a connection structure does not need to be additionally arranged, thereby reducing structural design difficulty, and reducing assembly difficulty and production costs. In addition, relatively small space inside the electronic device 10 is occupied.

In some examples, the charging interface 90 includes at least two ground pins 91. There are a corresponding quantity of metal pads 711b arranged on the first circuit board 70. There are a corresponding quantity of avoidance holes 210 provided on the metal reinforcement member 200.

In the embodiments of this application, the electronic device 10 further includes a metal middle frame 31. The ground portion 112 of the metal bracket 110 is electrically connected to the metal middle frame 31. The ground portion 112 of the metal bracket 110 may be grounded by using the metal middle frame 31. The metal middle frame 31 may be configured to provide a mounting base for a component inside the electronic device 10, and ensure that the entire electronic device 10 has good rigidity and deformation resistance. The second circuit board 80 and the charging interface 90 may both be connected to the metal middle frame 31. The first circuit board 70 may form a grounding path by using the metal reinforcement member 200, the conductive member 120, the metal bracket 110, and the metal middle frame 31, so that the grounding path of the first circuit board 70 is relatively short, which is beneficial to further reducing a current loss. The metal middle frame 31 may implement a supporting function and a grounding function, so that the metal middle frame 31 can be multiplexed, thereby reducing the structural design difficulty, and reducing the assembly difficulty and the production costs.

In some examples, the metal middle frame 31 includes an outer frame 311 and a middle plate 312 which are connected to each other. The outer frame 311 may be an annular frame. The middle plate 312 is located inside the outer frame 311. The ground portion 112 of the metal bracket 110 may be electrically connected to the middle plate 312 of the metal middle frame 31.

In the embodiments of this application, FIG. 11 is an enlarged view of a position W in FIG. 7. Referring to FIG. 4 and FIG. 11, the electronic device 10 further includes a conductive connection member 400. The ground portion 112 of the metal bracket 110 is connected to the metal middle frame 31 by using the conductive connection member 400. The conductive connection member 400 may be used as a transitional electrical connection member. When an assembly process of the second circuit board 80, the first circuit board 70, the metal reinforcement member 200, the conductive member 120, and the metal bracket 110 is completed, the ground portion 112 of the metal bracket 110 is connected to the metal middle frame 31 by using the conductive connection member 400. The conductive connection member 400 may ensure a stable and reliable connection between the ground portion 112 of the metal bracket 110 and the metal middle frame 31, and loosening does not easily occur between the ground portion 112 of the metal bracket 110 and the metal middle frame 31, helping reduce a possibility of a grounding failure or poor grounding caused by a poor connection between the ground portion 112 of the metal bracket 110 and the metal middle frame 31.

In some examples, the conductive connection member 400 includes a pressing portion 410 and an adapter portion 420. The adapter portion 420 is threadedly connected to the metal middle frame 31, to facilitate assembly of the adapter portion 420 and the metal middle frame 31, and ensure a stable connection state of the adapter portion 420 and the metal middle frame 31. The pressing portion 410 of the conductive connection member 400 abuts against the ground portion 112 of the metal bracket 110. The pressing portion 410 of the conductive connection member 400 applies a compressive stress on the ground portion 112 of the metal bracket 110, so that the pressing portion 410 of the conductive connection member 400 keeps a close contact state with the ground portion 112 of the metal bracket 110, thereby ensuring a stable connection state.

For example, the ground portion 112 of the metal bracket 110 and the conductive member 120 are spaced apart. The ground portion 112 of the metal bracket 110 is arranged close to the conductive member 120, which is beneficial to shortening a transmission path of the grounding current. The ground portion 112 of the metal bracket 110 has a mounting through hole. The adapter portion 420 of the conductive connection member 400 may pass through the mounting through hole of the ground portion 112 and is connected to the metal middle frame 31.

For example, there may be at least two conductive connection members 400. There also may be at least two ground portions 112 of the metal bracket 110. The conductive connection members 400 may be arranged in a one-to-one correspondence with the ground portions 112 of the metal bracket 110. The at least two conductive connection members 400 may both be configured to transmit a ground current, which effectively increases a quantity of grounding paths, and is beneficial to dispersing the current, helping further reduce a current loss.

In some examples, the metal bracket 110 includes a convex portion. The convex portion protrudes toward the metal middle frame 31. For example, the convex portion protrudes toward the middle plate 312 of the metal middle frame 31. The convex portion forms the ground portion 112. The pressing portion 410 abuts against a surface of the convex portion facing away from the metal middle frame 31. The convex portion of the metal bracket 110 is in contact with the metal middle frame 31. After the adapter portion 420 of the conductive connection member 400 is connected to the metal middle frame 31, the pressing portion 410 presses the convex portion, so that the metal bracket 110 and the metal middle frame 31 are grounded.

For example, a region that is on the metal bracket 110 and corresponds to the convex portion forms a recessed portion. At least part of the pressing portion 410 is located in the recessed portion of the metal bracket 110.

In the embodiments of this application, the second circuit board 80 may be located inside the metal bracket 110. The metal bracket 110 may form a limitation to the second circuit board 80, to increase position stability of the second circuit board 80. The ground portion 112 of the metal bracket 110 is electrically connected to the second circuit board 80. The ground portion 112 of the metal bracket 110 is grounded by using the second circuit board 80. The second circuit board 80 may implement a component mounting function and a grounding function, so that the second circuit board 80 may be multiplexed, thereby reducing the grounding structural design difficulty, and reducing the assembly difficulty and the production costs.

In some examples, the charging interface 90 may be electrically connected to the second circuit board 80. The second circuit board 80 may be a printed circuit board. The second circuit board 80 may be used as a secondary board.

In some examples, the ground portion 112 of the metal bracket 110 is respectively electrically connected to the metal middle frame 31 and the second circuit board 80, to implement grounding by using the metal middle frame 31 and the second circuit board 80. Therefore, a quantity of grounding path may be effectively increased, which is beneficial to dispersing the current, helping further reduce a current loss. The second circuit board 80 includes a ground point. The ground portion 112 of the metal bracket 110 is electrically connected to the ground point of the second circuit board 80.

In the embodiments of this application, the body portion 111 of the metal bracket 110 and the metal reinforcement member 200 are in a non-electrically connected state, that is, in a mutually insulated state, thereby avoiding a problem that a signal transmitted on the first circuit board 70 is interfered caused by a connection between the metal bracket 110 and the metal reinforcement member 200. In the thickness direction Z of the electronic device 10, there may be a gap between the body portion 111 of the metal bracket 110 and the metal reinforcement member 200, so that the body portion 111 of the metal bracket 110 and the metal reinforcement member 200 are not in contact with each other. An insulator (not shown in the figure) may be arranged on a surface of the body portion 111 of the metal bracket 110 facing the metal reinforcement member 200. The body portion 111 of the metal bracket 110 and the metal reinforcement member 200 may be insulated and isolated by using the insulator.

In some examples, an insulating varnish is sprayed on the surface of the metal bracket 110 to form the insulator.

In the descriptions of the embodiments of this application, it should be noted that, unless otherwise explicitly specified and defined, the terms "mount", "connect", and "connection" should be understood in a broad sense. For example, the connection may be a fixed connection, an indirect connection by using an intermediate medium, or communication inside two elements or an interactive relationship between two elements. A person of ordinary skill in the art may understand specific meanings of the foregoing terms in the embodiments of this application based on a specific situation.

In the embodiments of this application, it does not indicate or imply that an indicated apparatus or element needs to have a particular orientation or needs to be constructed and operated in a particular orientation, and therefore should not be construed as a limitation on the embodiments of this application. In the descriptions of the embodiments of this application, unless otherwise specifically limited, "a plurality of" means at least two.

The terms such as "first", "second", "third", and "fourth" (if present) in the specification and claims of the embodiments of this application and in the foregoing accompanying drawings are used for distinguishing between similar objects and are not necessarily used for describing a particular order or sequence. It should be understood that data used in this way is exchangeable in a proper case, so that the embodiments of this application described herein can be implemented in an order different from the order shown or described herein. Moreover, the terms "include", "have", and any other variants mean to cover non-exclusive inclusion. For example, a process, method, system, product, or device that includes a series of steps or units is not necessarily limited to those expressly listed steps or units, but may include other steps or units that are not expressly listed or inherent to the process, method, system, product, or device.

The term "a plurality of" in this specification means two or more. The term "and/or" in this specification is merely an association relationship for describing associated objects, and indicates that three relationships may exist. For example, A and/or B may indicate the following three cases: Only A exists, both A and B exist, and only B exists. In addition, the character "/" in this specification usually indicates an "or" relationship between the associated objects. In a formula, the character "/" indicates that the associated objects are in a "division" relationship.

It may be understood that various numerical numbers in the embodiments of this application are merely used for differentiation for ease of description, and are not used to limit the scope of the embodiments of this application.

It may be understood that in the embodiments of this application, sequence numbers of the foregoing processes do not mean execution sequences. The execution sequences of the processes should be determined according to functions and internal logic of the processes, and should not be construed as any limitation on the implementation processes of the embodiments of this application.

## Claims

1. An electronic device, comprising:
a charging interface;
a first circuit board, comprising a connection end, wherein the connection end comprises a ground terminal, and the connection end is electrically connected to the charging interface;
a metal reinforcement member, stacked with the connection end, wherein the metal reinforcement member is electrically connected to the ground terminal; and
a bracket assembly, comprising a metal bracket and a conductive member, wherein at least part of the connection end is located in the metal bracket, the metal bracket comprises a body portion and a ground portion, the ground portion is electrically connected to the body portion, the metal reinforcement member and the body portion are respectively electrically connected to the conductive member, and the ground portion is configured to be grounded.

2. The electronic device according to claim 1, wherein the metal reinforcement member is arranged between the body portion and the connection end, and the conductive member is arranged between the metal reinforcement member and the body portion.

3. The electronic device according to claim 2, wherein a concave portion is provided on at least one of the metal reinforcement member and the body portion, and at least part of the conductive member is located in space formed by the concave portion.

4. The electronic device according to claim 3, wherein the concave portion is provided on the body portion, the concave portion has an opening facing the metal reinforcement member, and a surface of the metal reinforcement member facing the concave portion is a plane.

5. The electronic device according to any one of claims 1 to 4, wherein one of the metal reinforcement member and the body portion is welded to the conductive member, and the other abuts against the conductive member.

6. The electronic device according to any one of claims 1 to 5, wherein the conductive member is an elastic structural member, and the metal reinforcement member and the body portion respectively apply a compressive stress to the conductive member.

7. The electronic device according to claim 6, wherein the conductive member is a metal structural member, the conductive member comprises a base body and an elastic foot, one of the metal reinforcement member and the body portion is connected to the base body, and the other is connected to the elastic foot.

8. The electronic device according to claim 7, wherein one of the metal reinforcement member and the body portion is welded to the base body, and the other abuts against the elastic foot.

9. The electronic device according to claim 7 or 8, wherein there are at least two elastic feet.

10. The electronic device according to any one of claims 1 to 9, wherein the conductive member is a metal elastic sheet.

11. The electronic device according to any one of claims 1 to 10, wherein the first circuit board is a flexible printed circuit board.

12. The electronic device according to any one of claims 1 to 11, wherein the charging interface comprises a ground pin, the ground terminal is electrically connected to the ground pin, and the metal reinforcement member is electrically connected to the ground pin.

13. The electronic device according to claim 12, wherein the ground terminal comprises a via hole and a metal pad, the metal pad is arranged in the via hole, the metal pad has a central through hole, the ground pin passes through the central through hole, and the ground pin is welded to the metal pad.

14. The electronic device according to claim 13, wherein the metal reinforcement member has an avoidance hole, the avoidance hole is provided corresponding to the central through hole of the metal pad, the ground pin passes through the avoidance hole, and the ground pin is welded to the metal reinforcement member.

15. The electronic device according to any one of claims 1 to 14, wherein the electronic device further comprises a metal middle frame, the ground portion is electrically connected to the metal middle frame, and the ground portion is grounded by using the metal middle frame.

16. The electronic device according to claim 15, wherein the electronic device further comprises a conductive connection member, and the ground portion is connected to the metal middle frame by using the conductive connection member.

17. The electronic device according to claim 16, wherein the conductive connection member comprises a pressing portion and an adapter portion, the adapter portion is threadedly connected the metal middle frame, and the pressing portion abuts against the ground portion.

18. The electronic device according to claim 17, wherein the metal bracket comprises a convex portion, the convex portion protrudes toward the metal middle frame, the convex portion forms the ground portion, and the pressing portion abuts against a surface of the convex portion facing away from the metal middle frame.

19. The electronic device according to any one of claims 1 to 18, wherein the electronic device further comprises a second circuit board, the second circuit board is located inside the metal bracket, the metal bracket forms a limitation to the second circuit board, the ground portion is electrically connected to the second circuit board, and the ground portion is grounded by using the second circuit board.

20. The electronic device according to any one of claims 1 to 19, wherein the electronic device further comprises the second circuit board, a battery, and a mainboard, the battery is arranged between the second circuit board and the mainboard, the battery is arranged on a side of the first circuit board, and the first circuit board is electrically connected to the mainboard.

21. The electronic device according to claim 19 or 20, wherein the electronic device further comprises the metal middle frame, the second circuit board is connected to the metal middle frame, and the second circuit board is a printed circuit board.

22. The electronic device according to any one of claims 1 to 21, wherein an insulator is arranged on a surface of the body portion facing the metal reinforcement member.
